# FASCICULE DE BREVET EUROPEEN

(11) **EP 4 390 347 B1**
(45) Date de publication et mention de la délivrance du brevet: **29.07.2026**
(21) Numéro de dépôt: 23218214.7
(22) Date de dépôt: 19.12.2023
(51) Int. Cl.: G01J 5/20, G01J 5/02

(54) **DISPOSITIF DE DETECTION D'UN RAYONNEMENT ELECTROMAGNETIQUE COMPORTANT UN DETECTEUR THERMIQUE SUR UN SUBSTRAT DE LECTURE DONT UN ELEMENT ELECTRONIQUE ACTIF EST SITUE AU PLUS PRES DU DETECTEUR THERMIQUE**
VORRICHTUNG ZUR ERFASSUNG ELEKTROMAGNETISCHER STRAHLUNG MIT EINEM THERMISCHEN DETEKTOR AUF EINEM AUSLESESUBSTRAT, DESSEN EIN AKTIVES ELEKTRONISCHES ELEMENT VOR DEM THERMISCHEN DETEKTOR ANGEORDNET IST
DEVICE FOR DETECTING ELECTROMAGNETIC RADIATION COMPRISING A THERMAL DETECTOR ON A READING SUBSTRATE, AN ACTIVE ELECTRONIC ELEMENT LOCATED AT THE MOST NEAR THE THERMAL DETECTOR

(30) Priorité: 21.12.2022 FR 2214113
(43) Date de publication de la demande: 26.06.2024
(73) Titulaire: Commissariat à l'Energie Atomique et aux Energies Alternatives, 75015 Paris (FR)
(72) Inventeur: BECKER, Sébastien, 38054 Grenoble cedex 09 (FR); LEDUC, Patrick, 38054 Grenoble cedex 09 (FR); PERRILLAT-BOTTONET, Thomas, 38054 Grenoble cedex 09 (FR)
(74) Mandataire: Santarelli

(56) Documents cités:
- WO-A1-2019/229353
- WO-A1-2020/074838
- FR-A1- 2 999 338
- FR-A1- 3 089 685

## Description

### DOMAINE TECHNIQUE

Le domaine de l'invention est celui des dispositifs de détection d'un rayonnement électromagnétique, comportant au moins un détecteur thermique à membrane absorbante suspendue au-dessus d'un substrat de lecture et thermiquement isolée de celui-ci. L'invention s'applique notamment au domaine de l'imagerie infrarouge ou térahertz, de la thermographie, voire de la détection de gaz.

### ÉTAT DE LA TECHNIQUE ANTÉRIEURE

Un dispositif de détection de rayonnement électromagnétique peut comporter des pixels sensibles formés chacun d'un détecteur thermique comportant une membrane absorbante suspendue et thermiquement isolée d'un substrat de lecture. La membrane absorbante comporte un absorbeur du rayonnement électromagnétique à détecter, associé à un transducteur thermométrique dont une propriété électrique varie en intensité en fonction de l'échauffement du transducteur. Un tel transducteur thermométrique peut être une thermistance (par exemple, un oxyde de vanadium ou de titane, voire du silicium amorphe), une diode (jonction pn ou pin), ou encore un transistor métal oxyde semiconducteur à effet de champ (MOSFET).

La température du transducteur thermométrique étant dépendante de son environnement, la membrane absorbante est isolée thermiquement du substrat de lecture. Pour cela, la membrane absorbante est généralement suspendue au-dessus du substrat de lecture par des piliers d'ancrage, et en est isolée thermiquement par des bras d'isolation thermique. Ces piliers d'ancrage et bras d'isolation thermique présentent également une fonction électrique en assurant la connexion électrique de la membrane absorbante au circuit de lecture.

Selon une configuration dite *'above IC'* (i.e. au-dessus du circuit intégré), décrite notamment dans le document EP2743659A1, les détecteurs thermiques sont réalisés au-dessus du circuit de lecture situé dans le substrat support. Le circuit de lecture se présente sous la forme d'un circuit intégré CMOS, et comporte une structure d'interconnexion située au-dessus d'une structure de lecture.

La structure d'interconnexion, ou structure BEOL (pour *Bock End Of Line,* en anglais), est formée de couches superficielles où sont définis des niveaux de métallisation, lesquels sont séparés verticalement par des couches diélectriques inter-métal (IMD pour *Inter Metal Dielectric,* en anglais), et sont connectés entre eux par des vias conducteurs.

La structure de lecture, ou structure FEOL (pour *Front End Of Line,* en anglais), est formée de couches profondes à base de semiconducteur où sont réalisés des éléments électroniques actifs (diodes, transistors...) et éventuellement des éléments électroniques passifs (condensateurs, résistances...). Les éléments électroniques sont connectés par les niveaux de métallisation aux détecteurs thermiques d'une part, et à au moins un plot de connexion externe d'autre part, ce dernier étant destiné à connecter le dispositif de détection à un dispositif électronique externe.

Comme le décrit notamment le document EP2894445A1, chaque pixel sensible peut comporter un élément électronique actif tel qu'un transistor MOS d'injection, connecté au détecteur thermique correspondant, par les niveaux de métallisation de la structure d'interconnexion. Le circuit de lecture de chaque pixel sensible peut être connecté à celui d'un ou plusieurs détecteurs thermiques de compensation situés par exemple en pied de colonne de la matrice de détection, et à un amplificateur transimpédance capacitif (CTIA).

Il existe cependant un besoin d'améliorer les performances d'un tel dispositif de détection.

Le document FR 2999338A1 présente un exemple de l'état de la technique.

### EXPOSÉ DE L'INVENTION

L'invention a pour objectif de remédier au moins en partie aux inconvénients de l'art antérieur, et plus particulièrement de proposer un dispositif de détection qui présente des performances électriques améliorées, notamment en termes de réponse impulsionnelle (limitation de la capacité parasite au niveau du nœud de lecture de l'élément sensible du pixel), voire en termes de résistance d'accès. Le dispositif de détection comporte au moins un détecteur thermique à membrane suspendue au-dessus d'un substrat de lecture. La configuration structurelle originale du substrat de lecture permet non seulement d'améliorer ces performances électriques du dispositif de détection, mais également conduit à un meilleur maintien mécanique des piliers d'ancrage.

Pour cela, l'objet de l'invention est un dispositif de détection d'un rayonnement électromagnétique selon la revendication 1, comprenant au moins un pixel sensible comportant un détecteur thermique, et comportant un substrat de lecture, comportant un circuit de lecture, lequel est formé d'un empilement de : une structure de lecture contenant des éléments électroniques actifs du circuit de lecture, dont au moins un premier élément électronique actif situé dans le pixel sensible et connecté au détecteur thermique ; et une structure d'interconnexion contenant différents niveaux de métallisation connectés aux éléments électroniques actifs, dont un niveau de métallisation supérieur situé du côté d'une face supérieure du substrat de lecture.

Le détecteur thermique comporte : une membrane absorbante, suspendue au-dessus d'une face supérieure du substrat de lecture et thermiquement isolé de celui-ci ; et des piliers d'ancrage, assurant la suspension de la membrane absorbante et la connexion électrique de celle-ci au circuit de lecture.

Selon l'invention, la structure de lecture est située sur et au contact de la structure d'interconnexion ; le premier élément électronique actif est connecté directement au niveau de métallisation supérieur ; et les piliers d'ancrage s'étendent continûment dans le substrat de lecture jusqu'à venir au contact du niveau de métallisation supérieur.

Le niveau de métallisation supérieur peut comporter plusieurs portions conductrices coplanaires, dont une première portion conductrice à laquelle un premier pilier d'ancrage du pixel sensible vient au contact, et à laquelle le premier élément électronique actif est connecté au moyen d'un premier via conducteur.

Les éléments électroniques actifs peuvent être connectés directement à des portions conductrices coplanaires du niveau de métallisation supérieur par des vias conducteurs, lesdits vias conducteurs et les piliers d'ancrage étant réalisés en les mêmes matériaux.

Le substrat de lecture comporte une structure supérieure située sur et au contact de la structure de lecture. La structure de lecture comporte : une première couche isolante dans laquelle sont situées les éléments électroniques actifs et au travers laquelle s'étendent des vias conducteurs entre les éléments électroniques actifs et des portions conductrices du niveau de métallisation supérieur ; et une deuxième couche isolante qui s'étend sur et au contact de la couche isolante et des éléments électroniques actifs. De plus, la structure supérieure comporte : une troisième couche isolante, qui s'étend sur et au contact de la deuxième couche isolante ; et un réflecteur reposant sur la troisième couche isolante.

La structure supérieure peut comporter une couche mince de protection, réalisée en un matériau inerte à l'acide fluorhydrique, s'étendant au-dessus de la troisième couche isolante, les première, deuxième et troisième couches isolantes étant réalisées en un matériau minéral.

Le réflecteur peut être un miroir de Bragg formé de plusieurs couches minces espacées verticalement les unes des autres et maintenues par des vias conducteurs traversant lesdites couches minces.

Le substrat de lecture peut être un premier substrat de lecture auquel est assemblé et connecté électriquement un deuxième substrat de lecture au niveau d'une face opposée à la face supérieure du premier substrat de lecture, le deuxième substrat de lecture comportant un empilement d'une deuxième structure de lecture et d'une deuxième structure d'interconnexion, dans lequel : des portions conductrices d'un niveau de métallisation inférieur de la deuxième structure d'interconnexion sont connectées à des éléments électroniques actifs de la deuxième structure de lecture ; et des portions conductrices d'un niveau de métallisation supérieur de la deuxième structure d'interconnexion sont au contact de portions conductrices d'un niveau de métallisation inférieur de la structure d'interconnexion du premier substrat de lecture.

Le dispositif de détection peut comporter un plot de connexion externe destiné à être connecté électriquement à un système électronique externe, s'étendant au travers de la structure de lecture pour venir au contact d'au moins une portion conductrice du niveau de métallisation supérieur.

L'invention porte également sur un procédé de fabrication d'un dispositif de détection selon l'une quelconque des caractéristiques précédentes, comportant les étapes suivantes :
- réalisation d'un premier empilement comportant une poignée sur laquelle repose une couche sacrificielle réalisée en un matériau minéral ;
- report et collage moléculaire, sur le premier empilement, d'un substrat SOI formé d'un substrat de silicium, d'une couche d'oxyde puis d'une couche mince de silicium, puis retrait du substrat de silicium ;
- réalisation de la structure de lecture, les éléments électroniques actifs étant réalisés à partir de la couche mince de silicium sur substrat SOI ;
- réalisation de la structure d'interconnexion sur la structure de lecture, des portions conductrices du niveau de métallisation supérieur étant directement connectés aux éléments électroniques actifs par des vias conducteurs ;
- retournement de l'empilement obtenu, puis retrait de la poignée ;
- réalisation de la membrane absorbante sur la couche sacrificielle ;
- suppression de la couche sacrificielle de manière à suspendre la membrane absorbante.

La réalisation de la structure de lecture peut comporter les étapes suivantes :
- dépôt d'une première couche isolante recouvrant les éléments électroniques actifs ;
- réalisation de vias conducteurs, s'étendant au travers de la première couche isolante pour venir au contact des éléments électroniques actifs ;
- réalisation des piliers d'ancrage, s'étendant au travers de la première couche isolante et de la couche sacrificielle pour venir au contact de la poignée.

Le procédé peut comporter, avant l'étape de report et de collage moléculaire, une étape de réalisation d'une structure supérieure, reposant sur la couche sacrificielle, comportant un réflecteur et une couche mince de protection, lesquels sont recouverts par une troisième couche isolante.

La couche mince de silicium du substrat SOI peut être recouverte d'une deuxième couche isolante, de sorte que, lors du report et du collage moléculaire, la deuxième couche isolante est mise au contact de la troisième couche isolante.

Lors de l'étape de réalisation de la membrane absorbante, un transducteur thermométrique, par exemple une thermistance, peut être réalisé.

En variante, lors de l'étape de réalisation du premier empilement, un transducteur thermométrique, par exemple une diode à jonction ou un transistor, peut être réalisé sur la poignée, puis être recouvert par la couche sacrificielle.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique et partielle, en coupe transversale, d'un dispositif de détection selon un mode de réalisation où le substrat de lecture comporte une structure de lecture située sur la structure d'interconnexion ;
la figure 1B est une vue schématique et partielle, en coupe transversale, d'un dispositif de détection selon une variante mode de réalisation ;
les figures 2A à 2H illustrent différentes étapes d'un procédé de fabrication d'un dispositif de détection identique ou similaire à celui de la fig.1A ;
les figures 3A à 3I illustrent différentes étapes d'un procédé de fabrication d'un dispositif de détection identique ou similaire à celui de la fig.1B ;
les figures 4A et 4B illustrent différentes étapes d'un procédé de fabrication d'un dispositif de détection similaire à celui de la fig.1B, où le réflecteur est un miroir de Bragg ;
les figures 5A à 5D illustrent différentes étapes d'un procédé de fabrication d'un dispositif de détection similaire à celui de la fig.1B, où un deuxième substrat de lecture est assemblé et connecté en face arrière au premier substrat de lecture.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif de détection d'un rayonnement électromagnétique, par exemple un rayonnement infrarouge ou térahertz. Le dispositif de détection peut ainsi être particulièrement adapté à détecter un rayonnement infrarouge de la gamme LWIR (*Long Wavelength Infrared,* en anglais) dont la longueur d'onde est comprise entre 8µm et 14µm environ.

Le dispositif de détection comporte au moins un pixel sensible, et de préférence une matrice de pixels sensibles. Un pixel sensible est formé d'un détecteur thermique, destiné à absorber le rayonnement électromagnétique, et connecté électriquement à un circuit de lecture situé dans le substrat sur lequel il repose.

Le détecteur thermique est du type à membrane absorbante, laquelle est suspendue au-dessus du substrat de lecture par des bras d'isolation thermique 12 et des piliers d'ancrage. Les piliers et les bras assurent la connexion électrique de la membrane absorbante au circuit de lecture. La membrane absorbante comporte un transducteur thermométrique de détection, c'est-à-dire un élément présentant une propriété électrique variant avec son échauffement. Un tel transducteur peut être une thermistance à base d'oxyde de vanadium ou de titane, voire de silicium amorphe. Il peut également être une diode à jonction pn ou pin, ou être un transistor MOS à effet de champ (MOSFET).

Le substrat de lecture est formé d'un empilement d'une structure d'interconnexion (de type BEOL) et d'une structure de lecture (de type FEOL). Chaque pixel sensible comporte au moins un élément électronique actif de la structure de lecture (par ex. un transistor MOS), connecté au détecteur thermique par le niveau de métallisation supérieur de la structure d'interconnexion. Par ailleurs, la structure d'interconnexion assure la connexion électrique des pixels sensibles à d'autres éléments électroniques actifs du circuit de lecture, ainsi qu'à un plot de connexion externe.

Les niveaux d'interconnexion sont formés chacun de portions conductrices coplanaires, celles-ci étant connectées à celles des niveaux d'interconnexion adjacents par des vias conducteurs. La structure d'interconnexion comporte donc plusieurs niveaux d'interconnexion parallèles et agencés verticalement les uns aux autres. Il comporte ainsi un premier niveau d'interconnexion, dit supérieur, et situé du côté du détecteur thermique, des niveaux d'interconnexions intermédiaires, et un dernier niveau d'interconnexion, dit inférieur, et situé du côté opposé au détecteur thermique.

Selon l'invention, dans le substrat de lecture, la structure de lecture est située sur la structure d'interconnexion, c'est-à-dire au-dessus de celle-ci. Autrement dit, elle est située du côté du détecteur thermique alors que la structure d'interconnexion est située du côté opposé. Cette configuration est l'inverse de la configuration habituelle dans les dispositifs de détection l'art antérieur, où la structure de lecture de type FEOL est située sous la structure d'interconnexion de type BEOL.

De plus, un premier élément électronique actif du pixel sensible (par exemple le transistor MOS) est connecté directement au niveau de métallisation supérieur, c'est-à-dire sans passer par des niveaux de métallisation intermédiaires. Cette configuration est également l'inverse de ce qui se fait habituellement dans l'art antérieur où le transistor MOS d'injection est généralement connecté au niveau de métallisation inférieur.

Enfin, les piliers d'ancrage s'étendent continûment dans le substrat de lecture jusqu'à venir au contact du niveau de métallisation supérieur. Par s'étendre continûment, on entend que les piliers d'ancrage s'étendent sans discontinuité des matériaux qui les constituent jusqu'au niveau de métallisation supérieur. Les piliers d'ancrage présentent donc une partie inférieure qui est située à l'intérieur du substrat de lecture, ce qui permet d'améliorer leur tenue mécanique.

Aussi, dans un même pixel sensible, les piliers d'ancrage et le premier élément électronique actif sont au contact de la ligne supérieure de métallisation. Cette configuration structurelle permet d'améliorer les performances électriques du dispositif de détection, dans la mesure où la résistance d'accès et les capacités parasites sont réduites, tout en renforçant la tenue mécanique des piliers d'ancrage.

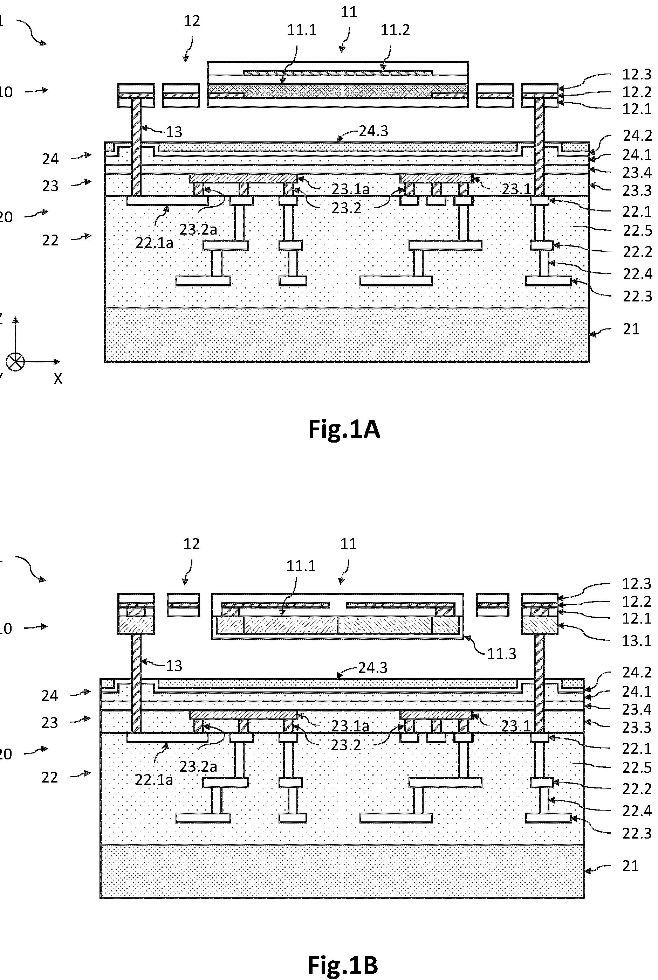

La figure 1A est une vue en coupe transversale, schématique et partielle, d'un dispositif de détection 1 selon un mode de réalisation. Dans cet exemple, le transducteur 11.1 est une thermistance.

On définit ici et pour la suite de la description un repère direct tridimensionnel orthogonal XYZ, où le plan XY est sensiblement parallèle au plan principal du substrat de lecture 20, et où l'axe Z est orienté en direction de la membrane absorbante 11. Dans la suite de la description, les termes « inférieur » et « supérieur » s'entendent comme étant relatifs à un positionnement croissant lorsqu'on s'éloigne du substrat de lecture 20 suivant la direction +Z.

Le substrat de lecture 20 comporte ici un empilement formé d'un substrat support 21, d'une structure d'interconnexion 22 (BEOL), d'une structure de lecture 23 (FEOL), et enfin ici d'une structure supérieure 24 qui comporte un réflecteur 24.3.

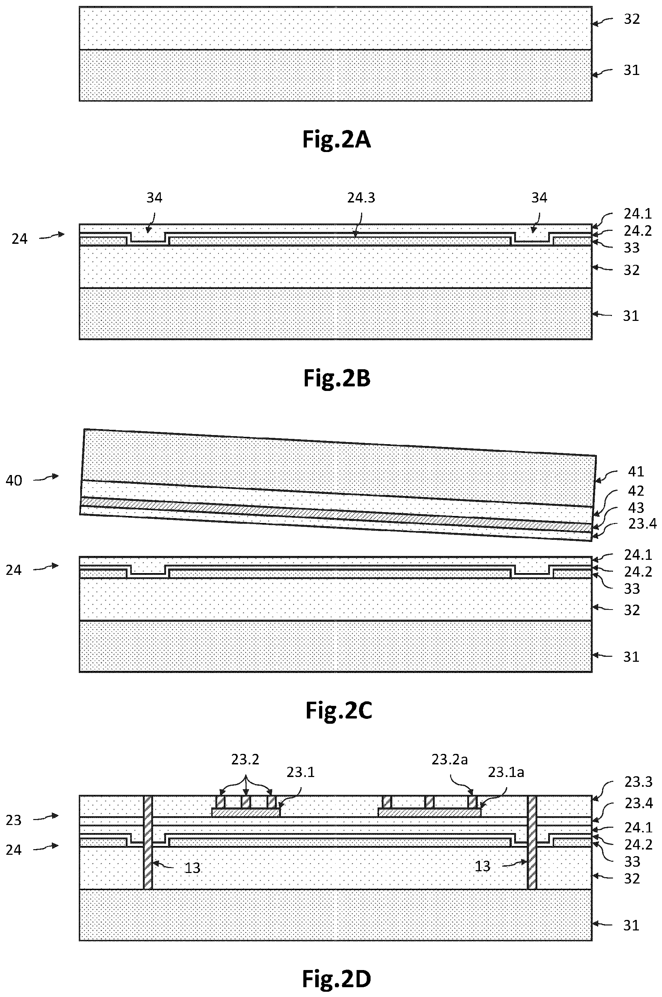

Le substrat support 21 est un substrat facultatif sur laquelle la structure d'interconnexion 22 repose et est en contact. Il s'agit d'une poignée qui a été utilisée lors du procédé de fabrication (cf. fig.2A à 2H). Il est ici un substrat en silicium épais par exemple de plusieurs centaines de microns.

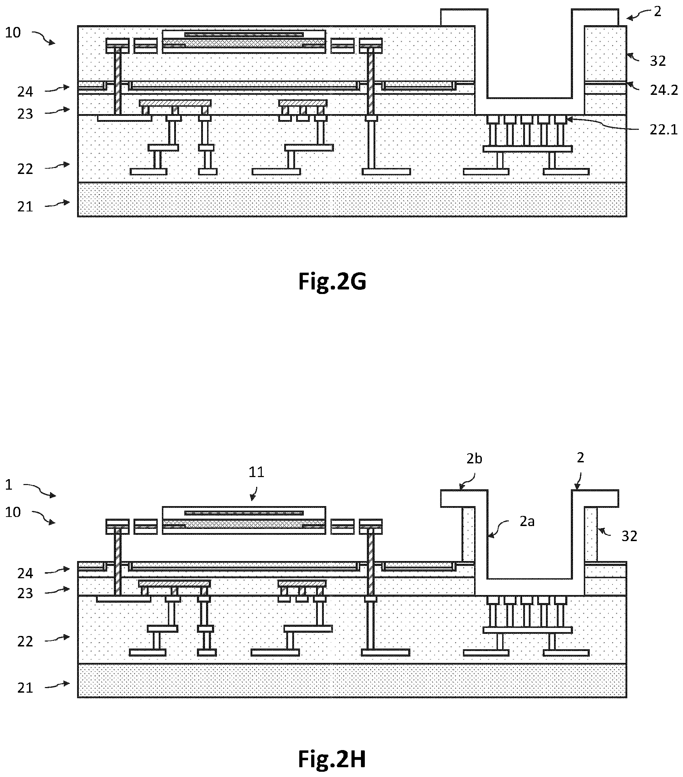

La structure d'interconnexion 22 est une partie du substrat de lecture 20 qui comporte une pluralité de niveaux de métallisation parallèles les uns aux autres. Chaque niveau de métallisation comporte des portions conductrices coplanaires, connectées aux portions conductrices des niveaux de métallisation adjacents par des vias conducteurs 22.4. Les vias conducteurs 22.4 traversent des couches isolantes 22.5 appelées diélectrique inter-métal (IMD), qui séparent les niveaux de métallisation deux à deux. La structure d'interconnexion 22 assure la connexion électrique, pour chaque pixel sensible, entre la membrane absorbante 11 et le ou les éléments électroniques actifs 23.1 associés à la membrane absorbante 11 en question. Elle assure également la connexion électrique de chaque pixel sensible à tout autre système de lecture adapté à lire l'information électrique délivrée par le dispositif de détection, voire à d'autres éléments électroniques actifs, par exemple à un amplificateur transimpédance capacitif (CTIA) situé en pied de colonne (dans le cas où le transducteur est une thermistance), ce CTIA étant également connecté à un ou plusieurs détecteurs thermiques de compensation. Elle assure enfin la connexion électrique à un plot de connexion externe 2 (cf. fig.2H).

Les niveaux de métallisation comportent donc, suivant la direction -Z, un premier niveau de métallisation, ou niveau de métallisation supérieur, formé des portions conductrices 22.1, et situé du côté de la face supérieure du substrat de lecture 20, et un dernier niveau de métallisation, ou niveau de métallisation inférieur, formé des portions conductrices 22.3, et situé du côté de la face inférieure du substrat de lecture 20. Des niveaux de métallisation intermédiaires (portions conductrices 22.2) sont présents entre les niveaux supérieur et inférieur. On comprend alors qu'il n'y a pas de niveaux de métallisation de la structure d'interconnexion 22 situés au-dessus du niveau supérieur, c'est-à-dire situés entre la face supérieure et le niveau de métallisation supérieur. Les portions conductrices 22.1, 22.2 et 22.3 et les vias conducteurs 22.4 peuvent être réalisés, par exemple, à base de cuivre, d'aluminium ou de tungstène, entre autres. Les couches isolantes 22.5 sont réalisées en un matériau minéral, par exemple, à base d'oxyde ou de nitrure de silicium.

La structure de lecture 23 est une partie du substrat de lecture 20 qui comporte les éléments électroniques actifs ou passifs qui sont connectés aux pixels sensibles, voire à un ou à des pixels de compensation. Les éléments électroniques actifs 23.1 peuvent être de type transistor, diode (par exemple photodiode, diode électroluminescente...), et les éléments électroniques passifs peuvent être des condensateurs, résistances.... La structure de lecture 23 est située au-dessus de la structure d'interconnexion 22 suivant l'axe vertical Z, c'est-à-dire qu'elle est située entre la face supérieure du substrat de lecture 20 et la structure d'interconnexion 22.

Pour chaque pixel sensible, les éléments électroniques actifs 23.1 sont connectés au niveau de métallisation supérieur, et plus précisément aux portions conductrices 22.1 par l'intermédiaire de vias conducteurs 23.2. Les éléments électroniques actifs 23.1 sont situés ici sous la membrane absorbante 11 dans le plan XY, et au-dessus du niveau de métallisation supérieur. Les éléments électroniques actifs 23.1 sont ici directement connectés aux portions conductrices 22.1 par les vias conducteurs 23.2, c'est-à-dire que chaque via conducteur 23.2 est au contact d'un élément électronique actif 23.1 et d'une portion conductrice 22.1. Un ou des vias 23.2 peuvent également être raccordés à un ou à des éléments électroniques passifs. Sauf indication contraire, lorsque l'on fait référence à deux éléments connectés directement entre eux, on entend qu'ils sont connectés par un via conducteur, sans passer par un niveau de métallisation intermédiaire.

D'autres éléments électroniques actifs 23.1 sont situés en pied de colonne, notamment pour définir le CTIA mentionné plus haut. Ils sont donc décalés dans le plan XY vis-à-vis des pixels sensibles. Ils sont également situés entre la face supérieure et la structure d'interconnexion 22.

Selon un mode de réalisation, dans chaque pixel sensible, un premier élément électronique actif 23.1a est connecté directement à une première portion conductrice 22.1a du niveau de métallisation supérieur par au moins un premier via conducteur 23.2a. Comme décrit plus loin, cette portion conductrice 22.1a est également en contact avec l'un des piliers d'ancrage 13. Cette configuration permet de réduire la résistance d'accès entre l'élément électronique actif 23.1a, par exemple ici le transistor MOS d'injection, et la membrane absorbante 11, et de réduire également les capacités parasites.

Les vias conducteurs 23.2 des éléments électroniques actifs 23.1, connectant directement ces derniers au niveau de métallisation supérieur, peuvent être réalisés en le ou les mêmes matériaux que ceux des piliers d'ancrage 13. A titre d'exemple, les vias conducteurs 23.2 peuvent être formés d'une enveloppe par exemple de Ti/TiN ou de Ta/TaN, comme décrit notamment dans le document EP2743659 mentionné plus haut) qui entoure un cœur de cuivre Cu et/ou de tungstène W. Les éléments électroniques actifs 23.1 sont réalisés à partir d'une couche semiconductrice 43 (cf. fig.2C à 2E), réalisée par exemple à base de silicium, et sont entourés d'une ou plusieurs couches isolantes 23.3 et 23.4 en un matériau diélectrique. Dans cet exemple, les éléments électroniques actifs 23.1 sont situés dans une couche isolante 23.3 et sont recouverts d'une couche isolante 23.4. Cette couche isolante 23.4 est réalisée en un oxyde, et est collée par collage moléculaire oxyde/oxyde avec une couche isolante 24.1 également réalisée en un oxyde. Cette étape de report et de collage moléculaire est décrite plus loin en référence à la fig. 2D.

La structure supérieure 24 comporte ici la couche isolante 24.1, une couche mince de protection 24.2 et un réflecteur 24.3. La couche mince de protection 24.2 s'étend ici sur et au contact de la couche isolante 24.1. Elle est adaptée à assurer une protection du substrat de lecture 20 vis-à-vis d'une attaque chimique, par exemple en milieu acide HF (acide fluorhydrique), mise en œuvre pour graver la ou les couches minérales sacrificielles utilisées lors de la réalisation du dispositif de détection 1. Cette couche mince de protection 24.2 forme ainsi une couche hermétique et chimiquement inerte assurant une protection des couches diélectriques inter-métal 22.5 sous-jacentes vis-à-vis de l'attaque chimique, et est électriquement isolante pour éviter tout court-circuit. Elle peut être réalisée en alumine Al₂O₃, voire en nitrure ou fluorure d'aluminium, et peut présenter une épaisseur comprise entre quelques dizaines et quelques centaines de nanomètres, par exemple comprise entre 10nm et 500nm.

Le réflecteur 24.3 est adapté à réfléchir le rayonnement lumineux à détecter en direction de la membrane absorbante 11. Il est situé sous celle-ci dans le plan XY, et forme avec elle une cavité optique interférentielle quart d'onde, permettant de maximiser l'absorption du rayonnement lumineux par la membrane absorbante 11. Dans cet exemple, le réflecteur 24.3 est sur et au contact de la couche mince de protection 24.3, mais il est possible de le réaliser au contact de la couche isolante 24.1 et de le recouvrir de la couche mince de protection 24.2. Il peut être réalisé en au moins une couche de silicium de quelques centaines de nanomètres d'épaisseur, fortement dopé avec un niveau de dopage au moins égal à 10¹⁹ cm⁻³.

Le détecteur thermique 10 comporte une membrane absorbante 11, suspendue au-dessus du substrat de lecture 20 par des bras d'isolation thermique 12 et des piliers d'ancrage 13. La membrane absorbante 11 comporte le transducteur thermométrique 11.1, ici une thermistance. Les bras d'isolation thermique 12 et les piliers d'ancrage 13 sont électriquement conducteurs, et assurent la connexion électrique de la thermistance 11.1 au circuit de lecture. La membrane absorbante 11 et les bras d'isolation thermique 12 sont des éléments connus de l'homme du métier. Dans cet exemple, les bras 12 et ici la membrane absorbante 11 sont formés d'un empilement d'une couche isolante inférieure 12.1, d'une couche conductrice 12.2, et d'une couche isolante supérieure 12.3. La couche conductrice 12.2 s'étend horizontalement, dans le plan XY, jusqu'à venir au contact de la thermistance 11.1 pour assurer la polarisation électrique de cette dernière. Par ailleurs, la membrane absorbante 11 comporte une couche absorbante 11.2 (pour absorber le rayonnement lumineux à détecter), située au-dessus de la thermistance 11.1 et reposant sur une couche isolante intermédiaire. La couche absorbante 11.2 est recouverte par la couche isolante supérieure 12.3. Elle peut être réalisée en TiN d'une épaisseur de 8nm à 15nm environ de manière à obtenir une résistance de couche de 377Ω/carré environ.

Les piliers d'ancrage 13 peuvent être réalisés à base d'une enveloppe par exemple en Ti/TiN ou Ta/TaN, et d'un cœur par exemple en Cu et/ou W. Ils s'étendent verticalement, suivant l'axe Z, jusqu'aux bras d'isolation thermique 12, et viennent chacun au contact d'une portion conductrice 22.1 du niveau de métallisation supérieur. Aussi, ils traversent la couche mince de protection 24.2, la couche isolante 24.1, ainsi que les couches isolantes 23.4 et 23.3 de la structure de lecture 23. Ainsi, ils s'étendent continûment suivant l'axe Z pour venir au contact des portions conductrices 22.1 du niveau de métallisation supérieur. Par s'étendent continûment, on entend ici qu'il y a une continuité de matière des piliers d'ancrage 13 entre les bras 13 et les portions conductrices 22.1. En particulier, ils ne viennent pas au contact de portions conductrices qui seraient situées au-dessus du niveau de métallisation supérieur. Ainsi, chaque pilier d'ancrage 13 présente une partie inférieure qui est entourée par le matériau diélectrique des couches isolantes du substrat de lecture 20 (ici 24.2, 24.1, 23.4 et 23.3). De plus, au moins l'un des piliers d'ancrage 13 vient au contact de la première portion conductrice 22.1a du niveau de métallisation supérieur à laquelle est directement connecté le premier élément électronique actif 23.1a.

Ainsi, par la disposition de la structure de lecture 23 sur la structure d'interconnexion 22, et par le fait que les piliers d'ancrage 13 s'étendent continûment jusqu'à venir au contact des portions conductrices 22.1 du niveau de métallisation supérieur, il est possible de connecter, pour chaque pixel sensible, au moins un élément électronique actif 23.1 directement aux portions conductrices 22.1 du niveau de métallisation supérieur, et en particulier à l'une d'elles (22.1a) dont l'un des piliers d'ancrage 13 est au contact. Ainsi, on améliore à la fois la tenue mécanique des piliers d'ancrage 13, mais également on réduit la résistance d'accès ainsi que les capacités parasites. Les performances électriques du dispositif de détection 1 en sont améliorées, par exemple en termes de réponse impulsionnelle, de vitesse de lecture. Par ailleurs, comme détaillé par la suite, cette configuration permet de mettre en œuvre simplement des procédés de fabrication du dispositif de détection 1, lesquels diffèrent entre eux notamment par le fait que le transducteur 11.1 supporte, ou non, les hautes températures (autour de 1000°C) de la réalisation des éléments électroniques actifs 23.1. Dans l'exemple de la fig.1A, le transducteur 11.1 est une thermistance qui ne supporte pas ces hautes températures.

La figure 1B est une vue en coupe transversale, schématique et partielle, d'un dispositif de détection 1 selon un mode de réalisation. Dans cet exemple, le transducteur 11.1 est une diode (qui supporte les hautes températures, de l'ordre de 1000°C, nécessaires à la réalisation des éléments électroniques actifs 23.1). La diode 11.1 est formée à partir d'une couche semiconductrice et présente des portions dopées de type p et de type n, de manière à former, au niveau de la membrane absorbante 11, une jonction semiconductrice pn. La diode 11.1 est ici réalisée à base de silicium, de préférence monocristallin. La membrane absorbante 11 comporte une couche isolante inférieure 11.3 (passivation), sur laquelle la diode 11.1 repose et est au contact. Sur la diode 11.1 repose un empilement d'une couche isolante 12.1, d'une couche conductrice 12.2, et d'une couche isolante supérieure 12.3. Au niveau de la membrane absorbante 11, la couche conductrice 12.2 vient au contact des portions dopées de type p et n de la diode 11.1, et assure leur polarisation électrique. Elle s'étend ici au-dessus de la diode 11 et forme une couche absorbante du rayonnement lumineux à détecter.

Les figures 2A à 2H illustrent différentes étapes d'un procédé de fabrication d'un dispositif de détection 1 identique ou similaire à celui de la fig.1A. Dans cet exemple, le réflecteur 24.3 est réalisé en un matériau qui supporte les hautes températures de la réalisation des éléments électroniques actifs 23.1, et est donc ici réalisé avant ces derniers. En revanche, la thermistance 11.1 ne supporte pas ces hautes températures, et est donc réalisée après les éléments électroniques actifs 23.1.

En référence à la fig.2A, on dépose une couche sacrificielle 32, réalisée en un matériau minéral tel qu'un oxyde ou un nitrure de silicium, sur une poignée 31. La couche sacrificielle 32 est destinée à permettre la réalisation ultérieure de la membrane absorbante 11. Son épaisseur définira la distance de la cavité optique quart d'onde entre la membrane absorbante 11 et le réflecteur 24.3.

En référence à la fig.2B, on réalise ensuite le réflecteur 24.3 puis la couche mince de protection 24.2. Pour cela, on dépose une couche continue 33 de silicium surdopé sur et au contact de la couche sacrificielle 32. Puis, on réalise le réflecteur 24.3 par lithographie et gravure localisée de la couche de silicium 33. Des ouvertures 34 sont formées dans la couche de silicium 33 de manière à permettre ultérieurement la réalisation des piliers d'ancrage 13. Puis, la couche mince de protection 24.2 est déposée de manière conforme, de manière à recouvrir continûment le réflecteur 24.3 et à descendre dans les ouvertures 34 pour venir au contact de la couche sacrificielle 32. Enfin, la couche isolante 24.1, réalisée en un oxyde, est déposée de manière à recouvrir la couche mince de protection. Une planarisation est ensuite effectuée. Cet empilement du réflecteur 24.3, de la couche mince de protection 24.2 et de la couche isolante 24.1 forme la structure supérieure 24 du substrat de lecture 20.

En référence à la fig.2C, on assure un collage d'un substrat SOI 40 (substrat de silicium 41, couche d'oxyde enterré 42, puis couche mince de silicium 43 de préférence monocristallin) sur la couche isolante 24.1. Le collage est ici un collage moléculaire oxyde/oxyde. Pour cela, une couche isolante 23.4, réalisée en un oxyde, est déposée au préalable sur la couche mince de silicium 43. Les couches isolantes 23.4 et 24.1 sont alors mises en contact pour assurer le collage moléculaire.

En référence à la fig.2D, on effectue le retrait du substrat de silicium 41 (la couche d'oxyde enterré 42 peut être gardée au moins en partie), puis on réalise les éléments électroniques actifs 23.1 et 23.1a (lithographie, gravure, dépôt, dopage...). Lors de ces étapes, une température élevée peut être appliquée, de l'ordre de 1000°C. Cependant, le réflecteur 24.3 est réalisé ici en un matériau supportant ces hautes températures. On dépose ensuite une couche isolante 23.3 réalisée en un matériau diélectrique, ici en un oxyde, de manière à recouvrir les éléments électroniques actifs 23.1, 23.1a. Puis, on réalise les piliers d'ancrage 13 ainsi que les vias conducteurs 23.2. Ils sont alors préférentiellement réalisés en les mêmes matériaux. Les piliers d'ancrage 13 s'étendent ici continûment, i.e. avec continuité des matériaux qui les constituent, de la face supérieure de la couche isolante 23.3 jusqu'à la poignée 31. Ils traversent donc la couche isolante 23.3, la couche isolante 23.4, la couche isolante 24.1, la couche mince de protection 24.2, et enfin la couche sacrificielle 32. Les vias conducteurs 23.2 traversent la couche isolante 23.3 et viennent au contact des éléments électroniques actifs 23.1, 23.1a. Une planarisation est ensuite réalisée.

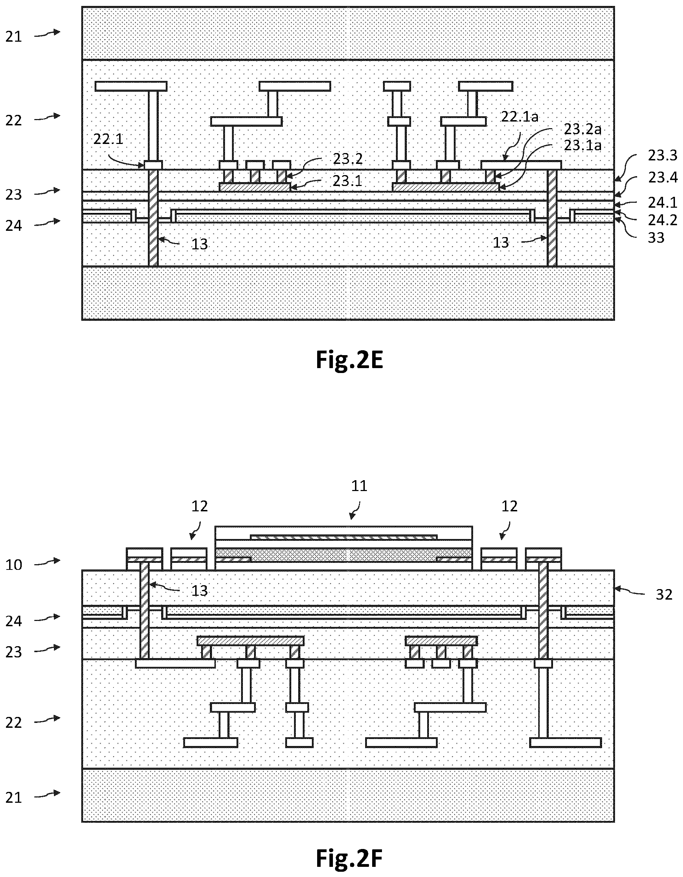

En référence à la fig.2E, on réalise ensuite la structure d'interconnexion 22, en commençant par ce qui sera le niveau de métallisation supérieur, puis les niveaux de métallisation intermédiaires, et enfin le niveau de métallisation inférieur. En particulier, les portions conductrices 22.1 du niveau de métallisation supérieur sont au contact des vias conducteurs 23.2 des éléments électroniques actifs 23.1. Ces derniers sont ainsi directement connectés au niveau de métallisation supérieur. De plus, une même portion conductrice 22.1a du niveau de métallisation supérieur est au contact d'un pilier d'ancrage 13 et d'un via conducteur 23.2a qui assure la connexion avec l'élément électronique actif 23.1a, ici un transistor MOS d'injection. Enfin, un substrat support 21 est assemblé à la structure d'interconnexion 22.

En référence à la fig.2F, on retourne l'empilement réalisé, et on retire la poignée 31, de manière à rendre libre une face de la couche sacrificielle 32. Ensuite, on réalise les bras d'isolation thermique 12 et la membrane absorbante 11 sur la couche sacrificielle 32. Les bras d'isolation thermique 12 sont au contact d'une extrémité des piliers d'ancrage 13 qui ont été réalisés au préalable.

En référence à la fig.2G, on réalise le plot de connexion externe 2 au travers de la couche sacrificielle 32, de manière à venir au contact d'au moins une portion conductrice 22.1 du niveau de métallisation supérieur. Le plot de connexion externe 2 est réalisé en au moins une couche métallique, déposée dans une échancrure formée au travers de la couche sacrificielle 32, de la couche mince de protection 24.2, et des couches isolantes sous-jacentes.

En référence à la fig.2H, on libère la membrane absorbante 11 en supprimant la couche sacrificielle 32, ici par attaque chimique par HF en phase vapeur. Le plot de connexion externe 2 peut comporter une partie supérieure périphérique 2b qui s'étend latéralement de préférence sur au moins 5µm à partir de la partie verticale 2a. Ainsi, lors de l'attaque à l'HF vapeur, une portion non gravée de la couche sacrificielle 32 peut être située sous la partie supérieure périphérique 2b, ce qui permet de renforcer la tenue mécanique du plot de connexion externe 2.

Ainsi, le procédé de fabrication permet de réaliser un dispositif de détection 1 dont les performances électriques, ainsi que la tenue mécanique des piliers d'ancrage 13, sont améliorées. Dans ce procédé, la thermistance 11.1 est sensible aux températures élevées générées lors de la réalisation des éléments électroniques actifs 23.1, ce qui explique qu'elle est réalisée après ces derniers.

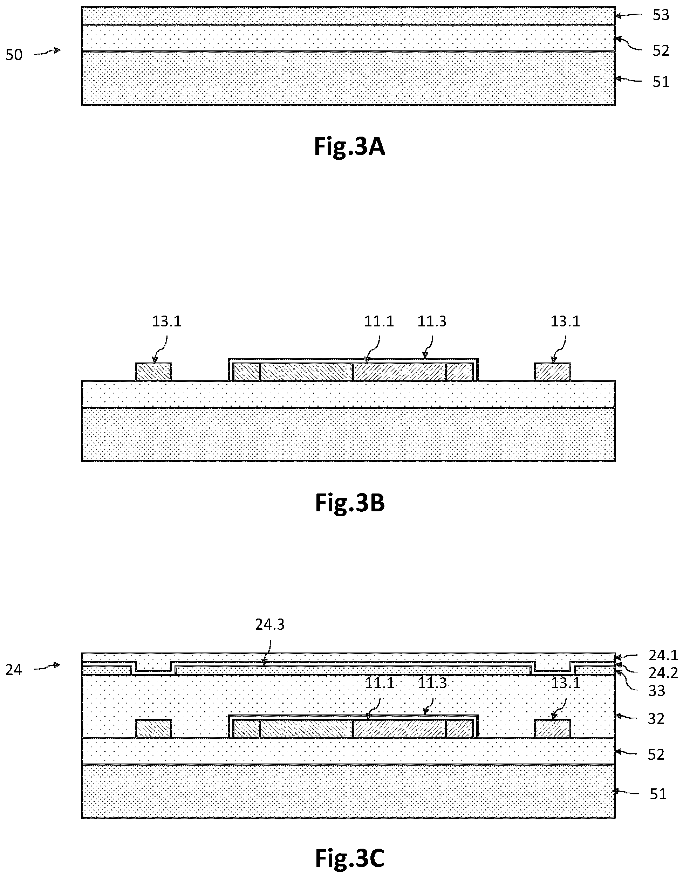

Les figures 3A à 3I illustrent différentes étapes d'un procédé de fabrication d'un dispositif de détection 1 identique ou similaire à celui de la fig.1B. Ce procédé diffère de celui des fig.2A à 2H essentiellement en ce que le transducteur thermométrique 11.1 est une diode à jonction pn réalisée avant la structure de lecture 23. Plusieurs étapes sont identiques ou similaires à celles du procédé des fig.2A à 2H et ne sont donc décrites que brièvement.

En référence à la fig.3A, on fournit un substrat SOI 50, formé d'un substrat de silicium 51, d'une couche d'oxyde enterré 52, puis d'une couche mince de silicium 53 de préférence monocristallin.

En référence à la fig.3B, on réalise le transducteur thermométrique 11.1, ici une diode à jonction pn, à partir de la couche mince de silicium 53. Pour cela, on structure la couche mince de silicium 53 par lithographie et gravure localisée, et on réalise les portions dopées de type p et de type n par implantation ionique localisée. Des plots semiconducteurs latéraux 13.1, issus de la couche mince de silicium 53 et de préférence dopés, peuvent être réalisés et sont destinés à être situés en tête des piliers d'ancrage 13. Par ailleurs, une couche mince de passivation 11.3 peut être déposée de manière à ne recouvrir que le transducteur 11.1.

En référence à la fig.3C, on dépose une couche sacrificielle 32 réalisée en un matériau minéral, par exemple en un oxyde de silicium, de manière à recouvrir le transducteur 11.1, les plots semiconducteurs latéraux 13.1, et la couche d'oxyde enterré 52. Cette couche sacrificielle 32 présente une épaisseur qui définira la dimension de la cavité optique quart d'onde entre la membrane absorbante 11 et le réflecteur 24.3. On réalise ensuite le réflecteur 24.3 puis la couche mince de protection 24.2, et enfin la couche isolante 24.1, de manière identique ou similaire à ce qui a été décrit en référence à la fig.2B.

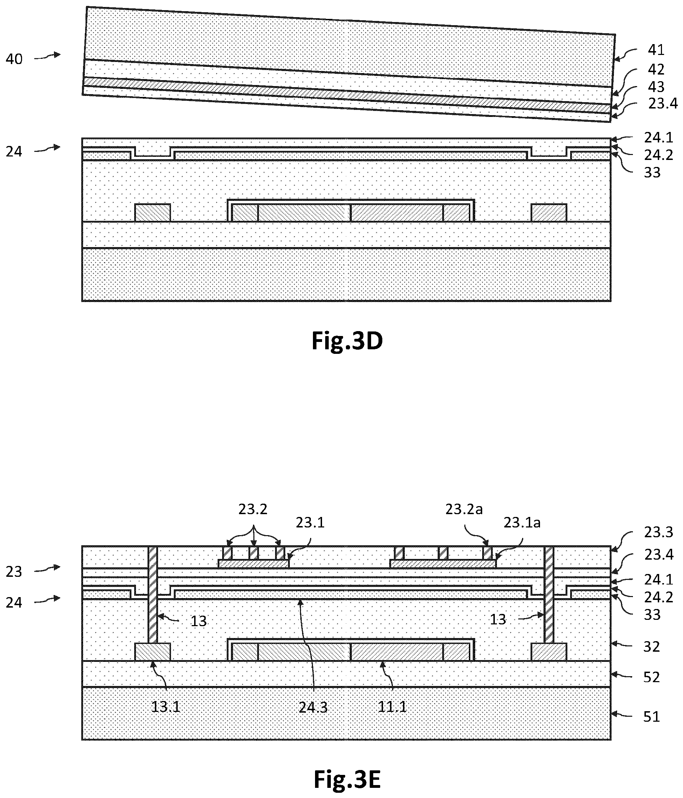

En référence à la fig.3D, on reporte et colle un substrat SOI 40 (substrat de silicium 41, couche d'oxyde enterré 42, couche mince de silicium 43 de préférence monocristallin), recouvert par la couche isolante 23.4 réalisée en un oxyde, à la couche isolante 24.1. Le collage est ici un collage moléculaire oxyde/oxyde.

En référence à la fig.3E, on retire le substrat 41. Puis on réalise la structure de lecture 23 et ses éléments électroniques actifs 23.1, 23.1a. Au cours de ces étapes, l'empilement peut être soumis à des températures élevées, de l'ordre de 1000°C, ce qui toutefois n'altère pas les propriétés du transducteur 11.1 ni celle du réflecteur 24.3.

Enfin, on réalise les piliers d'ancrage 13 et les vias conducteurs 23.2. Les piliers d'ancrage 13 s'étendent continûment de la face supérieure de la couche isolante 23.3 jusqu'au substrat de silicium 51. Ils traversent donc la couche isolante 23.3, la couche isolante 23.4, la couche isolante 24.1, la couche mince de protection 24.2, et enfin la couche sacrificielle 32, pour venir au contact des plots semiconducteurs latéraux 13.1. Les vias conducteurs 23.2 traversent la couche isolante 23.3 et viennent au contact des éléments électroniques actifs 23.1, 23.1a. Une planarisation est ensuite réalisée.

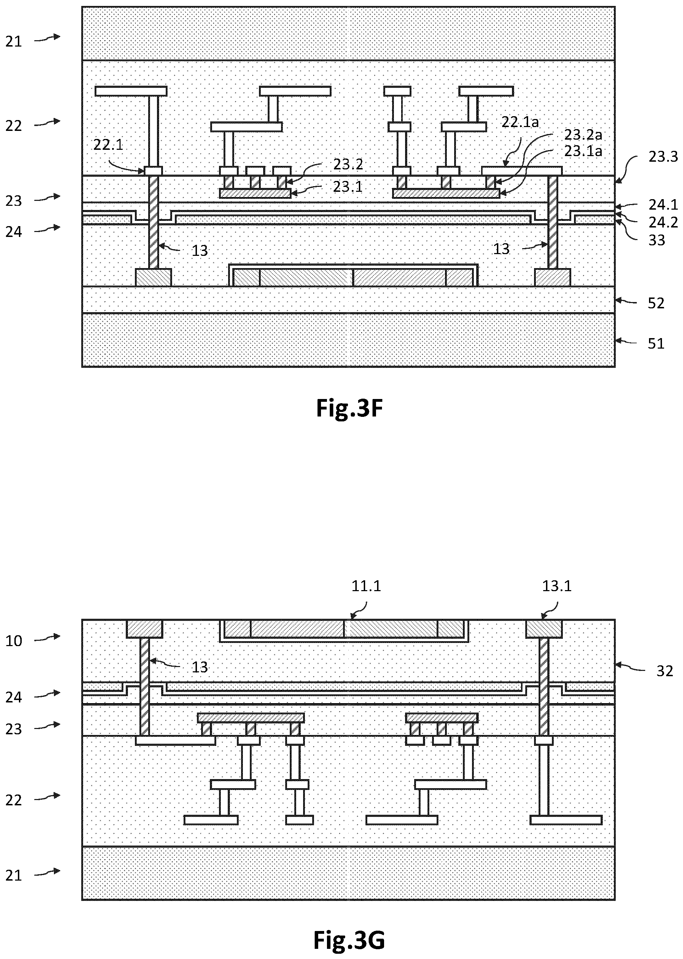

En référence à la fig.3F, on réalise la structure d'interconnexion 22, en commençant par ce qui sera le niveau de métallisation supérieur, puis les niveaux de métallisation intermédiaires, et enfin le niveau de métallisation inférieur. Les portions conductrices 22.1 du niveau de métallisation supérieur sont au contact des vias conducteurs 23.2 des éléments électroniques actifs 23.1. De plus, une même portion conductrice 22.1a du niveau de métallisation supérieur est au contact d'un pilier d'ancrage 13 et du via conducteur 23.2a qui assure la connexion avec l'élément électronique actif 23.1a (par exemple un transistor MOS dont la fonction dépend du type de lecture, par transfert de charges ou en tension. Lecture par transfert de charges : le MOS est utilisé pour transférer les charges (*transfert gate*)*.* Lecture en tension : le MOS est utilisé pour amplifier la tension électrique (*source follower*)*.* Enfin, un substrat support 21 est assemblé à la structure d'interconnexion 22.

En référence à la fig.3G, on retourne l'empilement réalisé, et on retire la poignée 51 puis la couche d'oxyde enterré 52. On rend ainsi libre une face supérieure du transducteur 11.1, ainsi ici que celle des plots semiconducteurs latéraux 13.1.

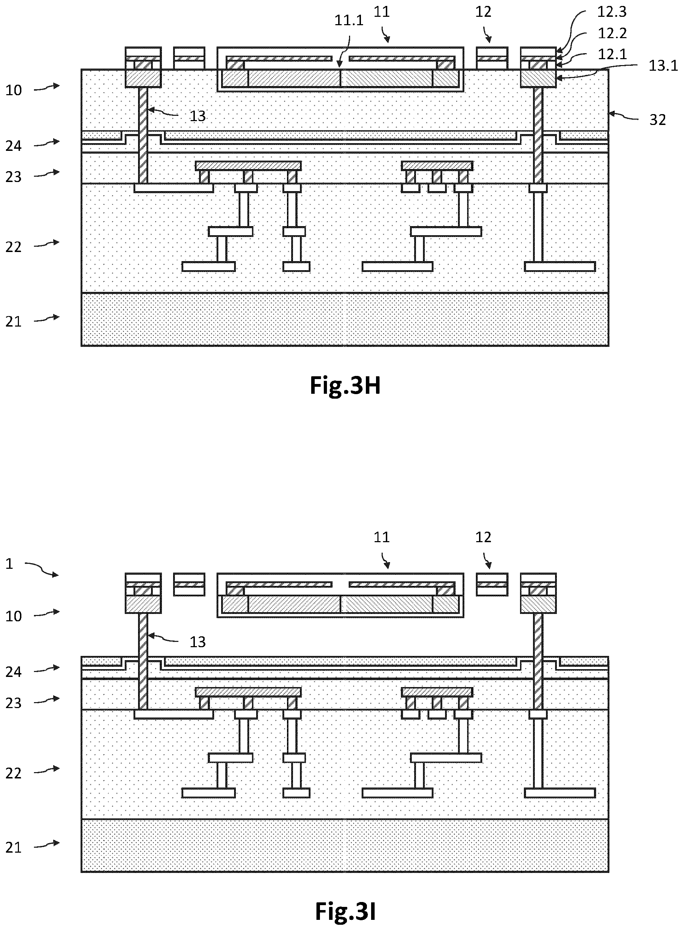

En référence à la fig.3H, on réalise les bras d'isolation thermique 12 et on finalise la réalisation de la membrane absorbante 11. On dépose ainsi la couche isolante 12.1, la couche conductrice 12.2, et la couche isolante 12.3. La couche conductrice 12.2 vient au contact des plots semiconducteurs latéraux 13.1, ainsi que des portions dopées de type p et de type n de la diode 11.1. Par ailleurs, on réalise également le plot de connexion externe (non représenté), comme décrit précédemment.

En référence à la fig.3I, on libère la membrane absorbante 11 en supprimant la couche sacrificielle, ici par attaque HF vapeur.

Ainsi, le procédé permet de fabriquer un dispositif de détection 1 ayant des performances électriques améliorées tout en augmentant la tenue mécanique des piliers d'ancrage 13 des détecteurs thermiques 10. Dans cet exemple, les transducteurs 11.1 des détecteurs thermiques 10 sont réalisés avant les éléments électroniques actifs 23.1 dans la mesure où ils peuvent supporter les hautes températures appliquées lors de la réalisation de ces derniers.

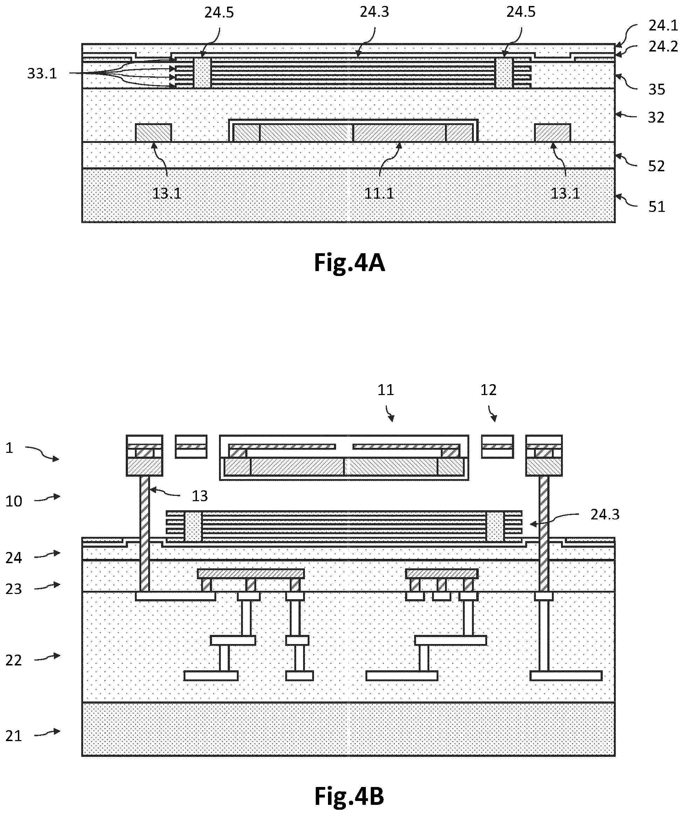

Les figures 4A et 4B illustrent différentes étapes d'un procédé de fabrication d'un dispositif de détection 1 selon un autre mode de réalisation. Dans cet exemple, chaque détecteur thermique 10 comporte un réflecteur 24.3 de type miroir de Bragg. Le miroir de Bragg est alors formé d'une succession de couches minces en un matériau de haut indice de réfraction (ici en silicium), distinctes et espacées verticalement les unes des autres. Il peut comporter au moins deux couches minces de haut indice. Dans cet exemple, le transducteur thermométrique est une diode à jonction, mais il pourrait être une thermistance, un transistor etc...

En référence à la fig.4A, on part ici d'un empilement similaire à celui de la fig.3B. Le transducteur 11.1 (diode à jonction pn) et les plots semiconducteurs latéraux 13.1 sont réalisés sur la couche d'oxyde enterré 52. Ils sont recouverts par la couche sacrificielle 32. On réalise ensuite un multicouche formé d'un empilement de couches minces 33.1 en un matériau de haut indice, ici en silicium, espacées deux à deux par une couche sacrificielle 35 en un matériau minéral, ici en un oxyde de silicium. Le multicouche est ensuite structuré par lithographie et gravure localisée. Des vias latéraux 24.5, réalisés ici en silicium, sont réalisés aux extrémités latérales du multicouche. Ils traversent les couches minces de silicium 33.1 et sont destinés à assurer leur maintien une fois que la couche sacrificielle 35 aura été supprimée. Enfin, la couche mince de protection 24.2 est déposée de manière à recouvrir l'ensemble, et la couche isolante 24.1 est déposée sur la couche mince de protection 24.2 puis planarisée.

En référence à la fig.4B, on réalise ensuite le report et le collage moléculaire du substrat SOI 40 (cf. fig.3D), la réalisation de la structure de lecture 23 (fig.3E), puis celle de la structure d'interconnexion 22 (fig.3F), puis la réalisation des bras d'isolation thermique 12 et la finalisation de la membrane absorbante 11 (fig.3G et 3H), et enfin la suspension de la membrane absorbante 11 par suppression des couches sacrificielles 32 et 35. Le réflecteur 24.3 est ainsi un miroir de Bragg formé d'une alternance de couches Si/vide. Les couches minces de silicium 33.1 sont maintenues suspendues par le biais des vias latéraux 24.5.

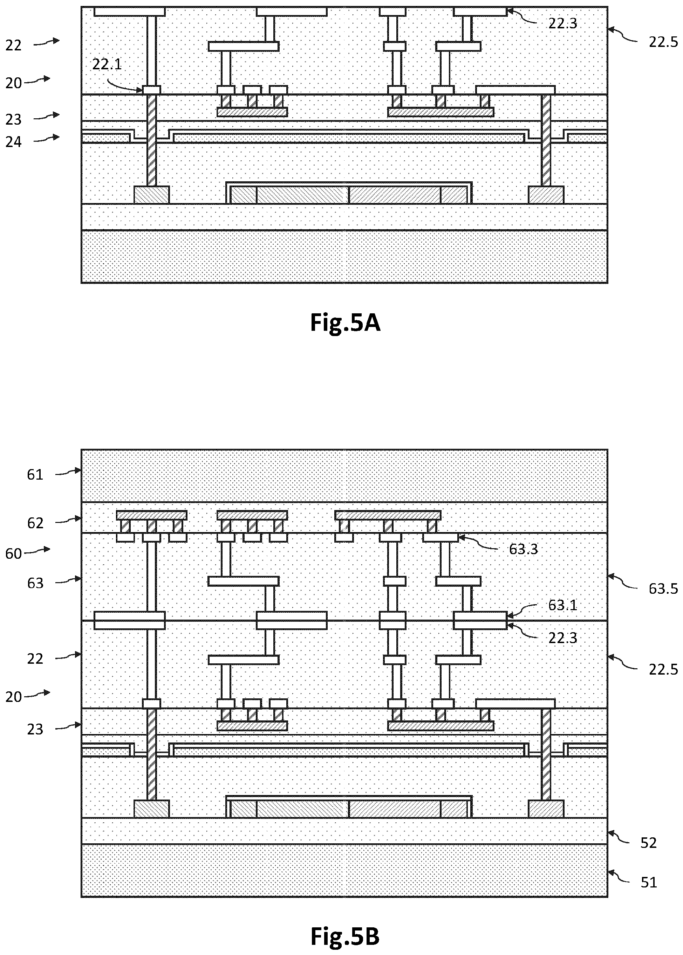

Les figures 5A à 5D illustrent différentes étapes d'un procédé de fabrication d'un dispositif de détection 1 selon un autre mode de réalisation. Dans cet exemple, le dispositif de détection 1 comporte un deuxième substrat de lecture 60, assemblé au premier substrat de lecture 20 en face arrière et connecté électriquement à ce dernier.

En référence à la fig.5A, on part d'un ensemble identique ou similaire à ceux des fig.2G ou 3F, à ceci près que, à la suite de la réalisation de la structure d'interconnexion 22, les portions conductrices 22.3 de dernier niveau de métallisation (niveau inférieur) affleurent une face de l'empilement. Elles ne sont donc pas recouvertes par une dernière couche isolante, et la couche support 21 des fig.2G et 3F n'est pas assemblé à l'empilement.

En référence à la fig.5B, on reporte et assemble par collage moléculaire un deuxième substrat de lecture 60 à la face libre de la structure d'interconnexion 22. Le deuxième substrat de lecture 60 est formé d'un empilement d'un substrat support 61, puis d'une structure de lecture 62, et enfin d'une structure d'interconnexion 63. Les portions conductrices 63.1 du niveau de métallisation supérieur de la structure d'interconnexion 63 affleurent la face libre du substrat de lecture 60. Ainsi, elles sont mises au contact des portions conductrices 22.3, et un collage moléculaire hybride oxyde/oxyde et métal/métal est réalisé.

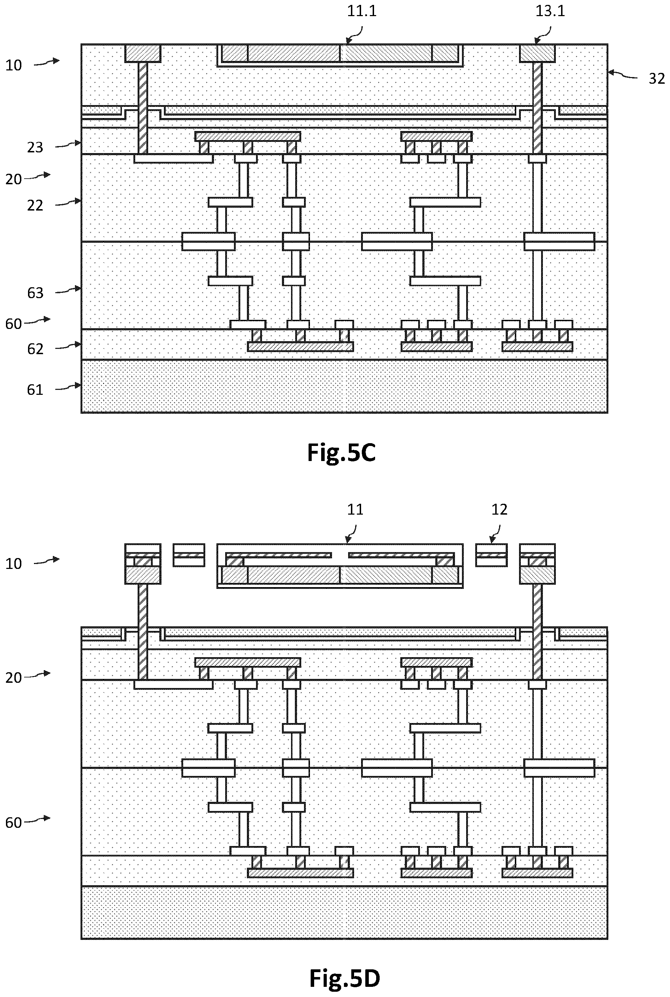

En référence à la fig.5C, on retourne l'ensemble, on retire le substrat 51 ainsi que la couche d'oxyde enterré 52, de manière à rendre libre une face supérieure du transducteur 11.1 et des plots semiconducteurs latéraux 13.1.

En référence à la fig.5D, on finalise la réalisation du détecteur thermique 10, par la réalisation des bras d'isolation thermique 12, de la membrane absorbante 11 et du plot de connexion externe (non représenté). La membrane absorbante 11 est ensuite suspendue par la suppression de la couche sacrificielle 32.

Ainsi, on obtient un dispositif de détection 1 comportant deux substrats de lecture, 20 et 60, empilés et connectés électriquement l'un à l'autre, où les deux structures d'interconnexion 22 et 63 sont en contact l'une de l'autre. Ceci est rendu possible par la configuration inversée des structures d'interconnexion 22 et de lecture 23 dans le substrat de lecture 20.

Des modes de réalisation particuliers viennent d'être décrits. Différentes variantes et modifications apparaîtront à l'homme du métier.

## Revendications

1. Dispositif de détection (1) d'un rayonnement électromagnétique, comprenant au moins un pixel sensible comportant un détecteur thermique (10), et comportant :
∘ un substrat de lecture (20), comportant un circuit de lecture, lequel est formé d'un empilement de :
• une structure de lecture (23) contenant des éléments électroniques actifs (23.1) du circuit de lecture,
- dont au moins un premier élément électronique actif (23.1a) situé dans le pixel sensible et connecté au détecteur thermique (10) ;
• une structure d'interconnexion (22) contenant différents niveaux de métallisation connectés aux éléments électroniques actifs (23.1),
- dont un niveau de métallisation supérieur situé du côté d'une face supérieure du substrat de lecture (20) ;
∘ le détecteur thermique (10), comportant :
• une membrane absorbante (11), suspendue au-dessus d'une face supérieure du substrat de lecture (20) et thermiquement isolé de celui-ci ;
• des piliers d'ancrage (13), assurant la suspension de la membrane absorbante (11) et la connexion électrique de celle-ci au circuit de lecture ;
∘ dans lequel :
• la structure de lecture (23) est située sur et au contact de la structure d'interconnexion (22) ;
• le premier élément électronique actif (23.1a) est connecté directement au niveau de métallisation supérieur ;
• les piliers d'ancrage (13) s'étendent continûment, sans discontinuité des matériaux qui les constituent, dans le substrat de lecture (20) jusqu'à venir au contact du niveau de métallisation supérieur ;
∘ **caractérisé en ce que** le substrat de lecture (20) comporte une structure supérieure (24) située sur et au contact de la structure de lecture (23),
∘ la structure de lecture (23) comportant :
• une première couche isolante (23.3) dans laquelle sont situées les éléments électroniques actifs (23.1) et au travers laquelle s'étendent des vias conducteurs (23.2) entre les éléments électroniques actifs (23.1) et des portions conductrices (22.1) du niveau de métallisation supérieur ;
• une deuxième couche isolante (23.4), réalisée en un oxyde, qui s'étend sur et au contact de la couche isolante et des éléments électroniques actifs (23.1) ;
∘ la structure supérieure (24) comportant :
• une troisième couche isolante (24.1), réalisée en un oxyde, qui s'étend sur et au contact de la deuxième couche isolante (23.4), les deuxième et troisième couches étant collées l'une à l'autre par collage moléculaire ;
• un réflecteur (24.3) reposant sur la troisième couche isolante (24.1).

2. Dispositif de détection (1) selon la revendication 1, dans lequel le niveau de métallisation supérieur comporte plusieurs portions conductrices coplanaires (22.1), dont une première portion conductrice (22.1a) à laquelle un premier pilier d'ancrage (13) du pixel sensible vient au contact, et à laquelle le premier élément électronique actif (23.1a) est connecté au moyen d'un premier via conducteur (23.2a).

3. Dispositif de détection (1) selon la revendication 1 ou 2, dans lequel les éléments électroniques actifs (23.1) sont connectés directement à des portions conductrices coplanaires (22.1) du niveau de métallisation supérieur par des vias conducteurs (23.2), lesdits vias conducteurs (23.2) et les piliers d'ancrage (13) étant réalisés en les mêmes matériaux.

4. Dispositif de détection (1) selon l'une quelconque des revendications 1 à 3, dans lequel la structure supérieure (24) comporte une couche mince de protection (24.2), réalisée en un matériau inerte à l'acide fluorhydrique, s'étendant au-dessus de la troisième couche isolante (24.1), les première, deuxième et troisième couches isolantes (23.3, 23.4, 24.1) étant réalisées en un matériau minéral.

5. Dispositif de détection (1) selon l'une quelconque des revendications 1 à 4, dans lequel le réflecteur (24.3) est un miroir de Bragg formé de plusieurs couches minces (33.1) espacées verticalement les unes des autres et maintenues par des vias conducteurs (24.5) traversant lesdites couches minces (33.1).

6. Dispositif de détection (1) selon l'une quelconque des revendications 1 à 5, dans lequel le substrat de lecture (20) est un premier substrat de lecture auquel est assemblé et connecté électriquement un deuxième substrat de lecture (60) au niveau d'une face opposée à la face supérieure du premier substrat de lecture (20), le deuxième substrat de lecture (60) comportant un empilement d'une deuxième structure de lecture (62) et d'une deuxième structure d'interconnexion (63), dans lequel :
∘ des portions conductrices (63.3) d'un niveau de métallisation inférieur de la deuxième structure d'interconnexion (63) sont connectées à des éléments électroniques actifs de la deuxième structure de lecture (62) ;
∘ des portions conductrices (63.1) d'un niveau de métallisation supérieur de la deuxième structure d'interconnexion (63) sont au contact de portions conductrices (22.3) d'un niveau de métallisation inférieur de la structure d'interconnexion (22) du premier substrat de lecture (20).

7. Dispositif de détection (1) selon l'une quelconque des revendications 1 à 6, comportant un plot de connexion externe (2) destiné à être connecté électriquement à un système électronique externe, s'étendant au travers de la structure de lecture (23) pour venir au contact d'au moins une portion conductrice (22.1) du niveau de métallisation supérieur.

8. Procédé de fabrication d'un dispositif de détection (1) selon l'une quelconque des revendications précédentes, comportant les étapes suivantes :
∘ réalisation d'un premier empilement comportant une poignée (31 ; 51) sur laquelle repose une couche sacrificielle (32) réalisée en un matériau minéral ;
∘ report et collage moléculaire, sur le premier empilement, d'un substrat SOI (40) formé d'un substrat de silicium (41), d'une couche d'oxyde (42) puis d'une couche mince de silicium (43), puis retrait du substrat de silicium (41) ;
∘ réalisation de la structure de lecture (23), les éléments électroniques actifs (23.1) étant réalisés à partir de la couche mince de silicium (43) sur substrat SOI (40),
∘ réalisation de la structure d'interconnexion (22) sur la structure de lecture (23), des portions conductrices du niveau de métallisation supérieur étant directement connectés aux éléments électroniques actifs (23.1) par des vias conducteurs (23.2) ;
∘ retournement de l'empilement obtenu, puis retrait de la poignée (31 ; 51) ;
∘ réalisation de la membrane absorbante (11) sur la couche sacrificielle (32) ;
∘ suppression de la couche sacrificielle (32) de manière à suspendre la membrane absorbante (11).

9. Procédé de fabrication selon la revendication 8, dans lequel la réalisation de la structure de lecture (23) comporte les étapes suivantes :
∘ dépôt d'une première couche isolante (23.3) recouvrant les éléments électroniques actifs (23.1);
∘ réalisation de vias conducteurs (23.2), s'étendant au travers de la première couche isolante (23.3) pour venir au contact des éléments électroniques actifs (23.1) ;
∘ réalisation des piliers d'ancrage (13), s'étendant au travers de la première couche isolante (23.3) et de la couche sacrificielle (32) pour venir au contact de la poignée (31 ; 51).

10. Procédé de fabrication selon la revendication 8 ou 9, comportant, avant l'étape de report et de collage moléculaire, une étape de réalisation d'une structure supérieure (24), reposant sur la couche sacrificielle (32 ; 52), comportant un réflecteur (24.3) et une couche mince de protection (24.2), lesquels sont recouverts par une troisième couche isolante (24.1).

11. Procédé de fabrication selon la revendication 10, dans lequel, la couche mince de silicium (43) du substrat SOI (40) est recouverte d'une deuxième couche isolante (23.4), de sorte que, lors du report et du collage moléculaire, la deuxième couche isolante (23.4) est mise au contact de la troisième couche isolante (24.1).

12. Procédé de fabrication selon l'une quelconque des revendications 8 à 11, dans lequel, lors de l'étape de réalisation de la membrane absorbante (11), un transducteur thermométrique (11.1), par exemple une thermistance, est réalisé.

13. Procédé de fabrication selon l'une quelconque des revendications 8 à 11, dans lequel, lors de l'étape de réalisation du premier empilement, un transducteur thermométrique (11.1), par exemple une diode à jonction ou un transistor, est réalisé sur la poignée (31 ; 51), puis est recouvert par la couche sacrificielle (32).

## Patentansprüche

1. Detektionsvorrichtung (1) für elektromagnetische Strahlung, die mindestens ein empfindliches Pixel umfasst, das einen Wärmedetektor (10) aufweist, und die Folgendes aufweist:
∘ ein Lesesubstrat (20), das eine Leseschaltung aufweist, gebildet aus einem Stapel von:
• einer Lesestruktur (23), die aktive elektronische Elemente (23.1) der Leseschaltung enthält,
- davon mindestens ein erstes aktives elektronisches Element (23.1a), das sich im empfindlichen Pixel befindet und mit dem Wärmedetektor (10) verbunden ist;
• einer Verbindungsstruktur (22), die verschiedene Metallisierungsebenen enthält, die mit den aktiven elektronischen Elementen (23.1) verbunden sind,
- davon eine obere Metallisierungsebene, die sich auf der Seite einer Oberseite des Lesesubstrats (20) befindet;
∘ den Wärmedetektor (10), der Folgendes aufweist:
• eine absorbierende Membran (11), die über eine Oberseite des Lesesubstrats (20) hängend und thermisch davon isoliert ist;
• Verankerungspfosten (13), die die Aufhängung der absorbierenden Membran (11) und die elektrische Verbindung dieser mit der Leseschaltung gewährleisten;
∘ und in dem:
• die Lesestruktur (23) sich auf und in Kontakt mit der Verbindungsstruktur (22) befindet;
• das erste aktive elektronische Element (23.1a) direkt mit der oberen Metallisierungsebene verbunden ist;
• die Verankerungspfosten (13) sich kontinuierlich ohne Unterbrechung der sie bildenden Materialien in das Lesesubstrat (20) erstrecken, bis sie mit der oberen Metallisierungsebene in Kontakt kommen;
∘ **dadurch gekennzeichnet, dass** das Lesesubstrat (20) eine obere Struktur (24) aufweist, die sich auf und in Kontakt mit der Lesestruktur (23) befindet,
∘ wobei die Lesestruktur (23) Folgendes aufweist:
• eine erste Isolierschicht (23.3), in der sich die aktiven elektronischen Elemente (23.1) befinden und durch die sich leitende Vias (23.2) zwischen den aktiven elektronischen Elementen (23.1) und leitenden Abschnitten (22.1) der oberen Metallisierungsebene erstrecken;
• eine zweite Isolierschicht (23.4), hergestellt aus einem Oxid, die sich auf und in Kontakt mit der Isolierschicht und den aktiven elektronischen Elementen (23.1) erstreckt;
∘ wobei die obere Struktur (24) Folgendes aufweist:
• eine dritte Isolierschicht (24.1), hergestellt aus einem Oxid, das sich auf und in Kontakt mit der zweiten Isolierschicht (23.4) erstreckt, wobei die zweite und dritte Schicht durch molekulare Verklebung miteinander verklebt sind;
• einen Reflektor (24.3), der auf der dritten Isolierschicht (24.1) aufliegt.

2. Detektionsvorrichtung (1) nach Anspruch 1, wobei die obere Metallisierungsebene mehrere koplanare leitfähige Abschnitte (22.1) aufweist, darunter einen ersten leitfähigen Abschnitt (22.1a), mit dem ein erster Verankerungspfosten (13) des empfindlichen Pixels in Kontakt kommt, und mit dem das erste aktive elektronische Element (23.1a) mittels eines ersten leitenden Vias (23.2a) verbunden ist.

3. Detektionsvorrichtung (1) nach Anspruch 1 oder 2, wobei die aktiven elektronischen Elemente (23.1) über leitende Vias (23.2) direkt mit koplanaren leitenden Abschnitten (22.1) der oberen Metallisierungsebene verbunden sind, wobei die leitenden Vias (23.2) und die Verankerungssäulen (13) aus denselben Materialien hergestellt sind.

4. Detektionsvorrichtung (1) nach einem der Ansprüche 1 bis 3, wobei die obere Struktur (24) eine dünne Schutzschicht (24.2) aufweist, die aus einem fluorwasserstoffsäureinerten Material hergestellt ist und sich über die dritte Isolierschicht (24.1) erstreckt, wobei die erste, zweite und dritte Isolierschicht (23.3, 23.4, 24.1) aus einem mineralischen Material hergestellt sind.

5. Detektionsvorrichtung (1) nach einem der Ansprüche 1 bis 4, wobei der Reflektor (24.3) ein Bragg-Spiegel ist, der aus mehreren vertikal voneinander beabstandeten Dünnschichten (33.1) gebildet ist und von leitenden Vias (24.5) gehalten wird, die die Dünnschichten (33.1) durchqueren.

6. Detektionsvorrichtung (1) nach einem der Ansprüche 1 bis 5, wobei das Lesesubstrat (20) ein erstes Lesesubstrat ist, an dem ein zweites Lesesubstrat (60) an einer gegenüberliegenden Seite der Oberseite des ersten Lesesubstrats (20) montiert und elektrisch verbunden ist, wobei das zweite Lesesubstrat (60) ein Stapel einer zweiten Lesestruktur (62) und einer zweiten Verbindungsstruktur (63) aufweist, wobei:
∘ leitfähige Abschnitte (63.3) einer unteren Metallisierungsebene der zweiten Verbindungsstruktur (63) mit aktiven elektronischen Elementen der zweiten Lesestruktur (62) verbunden sind;
∘ leitende Abschnitte (63.1) einer oberen Metallisierungsebene der zweiten Verbindungsstruktur (63) mit leitenden Abschnitten (22.3) einer unteren Metallisierungsebene der Verbindungsstruktur (22) des ersten Lesesubstrats (20) in Kontakt sind.

7. Detektionsvorrichtung (1) nach einem der Ansprüche 1 bis 6, die einen externen Anschlussstift (2) aufweist, der dazu bestimmt ist, elektrisch mit einem externen elektronischen System verbunden zu werden, der sich durch die Lesestruktur (23) erstreckt, um mit mindestens einem leitenden Abschnitt (22.1) der oberen Metallisierungsebene in Kontakt zu kommen.

8. Herstellungsverfahren einer Detektionsvorrichtung (1) nach einem der vorhergehenden Ansprüche, das folgende Schritte aufweist:
∘ Herstellen eines ersten Stapels, der einen Griff (31; 51) aufweist, auf dem eine Opferschicht (32) aus einem mineralischen Material aufliegt;
∘ Übertragen und molekulares Verkleben, auf den ersten Stapel, eines SOI-Substrats (40), das aus einem Siliziumsubstrat (41), einer Oxidschicht (42) und anschließend einer dünnen Siliziumschicht (43) gebildet ist, und anschließend Entfernen des Siliziumsubstrats (41);
∘ Ausführen der Lesestruktur (23), wobei die aktiven elektronischen Elemente (23.1) aus der dünnen Siliziumschicht (43) auf SOl-Substrat (40) hergestellt sind,
∘ Herstellen der Verbindungsstruktur (22) an der Lesestruktur (23), wobei leitende Abschnitte der oberen Metallisierungsebene direkt mit den aktiven elektronischen Elementen (23.1) über leitende Vias (23.2) verbunden sind;
∘ Drehen des erhaltenen Stapels und anschließendes Entfernen des Griffs (31; 51);
∘ Herstellen der absorbierenden Membran (11) auf der Opferschicht (32);
∘ Entfernen der Opferschicht (32), so dass die absorbierende Membran (11) aufgehängt ist.

9. Herstellungsverfahren nach Anspruch 8, wobei die Herstellung der Lesestruktur (23) folgende Schritte aufweist:
∘ Aufbringen einer ersten Isolierschicht (23.3), die die aktiven elektronischen Elemente (23.1) bedeckt;
∘ Herstellen von leitenden Vias (23.2), die sich durch die erste Isolierschicht (23.3) erstrecken, um mit den aktiven elektronischen Elementen (23.1) in Kontakt zu kommen;
∘ Herstellen der Verankerungspfosten (13), die sich durch die erste Isolierschicht (23.3) und die Opferschicht (32) erstrecken, um mit dem Griff (31; 51) in Kontakt zu kommen.

10. Herstellungsverfahren nach Anspruch 8 oder 9, das vor dem Schritt der molekularen Übertragung und Verklebung einen Schritt zur Herstellung einer oberen Struktur (24) auf der Opferschicht (32; 52) aufweist, die einen Reflektor (24.3) und eine dünne Schutzschicht (24.2) aufweist, die von einer dritten Isolierschicht (24.1) bedeckt sind.

11. Herstellungsverfahren nach Anspruch 10, wobei die Siliziumdünnschicht (43) des SOI-Substrats (40) mit einer zweiten Isolierschicht (23.4) überzogen ist, so dass bei der Übertragung und molekularen Verklebung die zweite Isolierschicht (23.4) mit der dritten Isolierschicht (24.1) in Kontakt kommt.

12. Herstellungsverfahren nach einem der Ansprüche 8 bis 11, wobei beim Herstellungsschritt der Absorptionsmembran (11) ein thermometrischer Wandler (11.1), beispielsweise ein Thermistor, hergestellt wird.

13. Herstellungsverfahren nach einem der Ansprüche 8 bis 11, wobei beim Herstellungsschritt des ersten Stapels ein thermometrischer Wandler (11.1), beispielsweise eine Diaphragmadiode oder ein Transistor, am Griff (31; 51) hergestellt und dann mit der Opferschicht (32) bedeckt wird.

## Claims

1. A device (1) for detecting an electromagnetic radiation, comprising at least one sensitive pixel including a thermal detector (10), and including:
∘ a readout substrate (20), including a readout circuit, which is formed of a stack of:
• a readout structure (23) containing active electronic elements (23.1) of the readout circuit,
- including at least one first active electronic element (23.1a) located in the sensitive pixel and connected to the thermal detector (10);
• an interconnection structure (22) containing different metallization levels connected to the active electronic elements (23.1),
- including an upper metallization level located on the side of an upper face of the readout substrate (20);
∘ the thermal detector (10), including:
• an absorbing membrane (11), suspended above an upper face of the readout substrate (20) and thermally insulated from the latter;
• anchor pillars (13), ensuring suspension of the absorbing membrane (11) and the electrical connection of the latter to the readout circuit;
∘ wherein:
• the readout structure (23) is located over and in contact with the interconnection structure (22);
• the first active electronic element (23.1a) is directly connected to the upper metallization level;
• the anchor pillars (13) continuously extend in the readout substrate (20), with no discontinuity in the materials which form them, until coming into contact with the upper metallization level;
∘ the readout substrate (20) including:
• an upper structure (24) located over and in contact with the readout structure (23),
∘ the readout structure (23) including:
• a first insulating layer (23.3) in which the active electronic elements (23.1) are located and throughout which conductive vias (23.2) extend between the active electronic elements (23.1) and conductive portions (22.1) of the upper metallization level;
• a second insulating layer (23.4), made of oxide, which extends over and in contact with the insulating layer and the active electronic elements (23.1);
∘ the upper structure (24) including:
• a third insulating layer (24.1), made of oxide, which extends over and in contact with the second insulating layer (23.4), the second and third layers being bonded one to the other by molecular bonding;
• a reflector (24.3) resting on the third insulating layer (24.1).

2. The detection device (1) according to claim 1, wherein the upper metallization level includes several coplanar conductive portions (22.1), including a first conductive portion (22.1a) with which a first anchor pillar (13) of the sensitive pixel comes into contact, and to which the first active electronic element (23.1a) is connected by means of a first conductive via (23.2a).

3. The detection device (1) according to claim 1, wherein the active electronic elements (23.1) are directly connected to coplanar conductive portions (22.1) of the upper metallization level through conductive vias (23.2), said conductive vias (23.2) and the anchor pillars (13) being made of the same materials.

4. The detection device (1) according to claim 1, wherein the upper structure (24) includes a protective thin layer (24.2), made of a material inert to hydrofluoric acid, extending over the third insulating layer (24.1), the first, second and third insulating layers (23.3, 23.4, 24.1) being made of a mineral material.

5. The detection device (1) according to claim 1, wherein the reflector (24.3) is a Bragg mirror formed of several thin layers (33.1) spaced vertically apart from one another and held by conductive vias (24.5) crossing said thin layers (33.1).

6. The detection device (1) according to claim 1, wherein the readout substrate (20) is a first readout substrate to which a second readout substrate (60) is assembled and electrically connected at the level of a face opposite to the upper face of the first readout substrate (20), the second readout substrate (60) including a stack of a second readout structure (62) and of a second interconnection structure (63), wherein:
∘ conductive portions (63.3) of a lower metallization level of the second interconnection structure (63) are connected to active electronic elements of the second readout structure (62);
∘ conductive portions (63.1) of an upper metallization level of the second interconnection structure (63) are in contact with conductive portions (22.3) of a lower metallization level of the interconnection structure (22) of the first readout substrate (20).

7. The detection device (1) according to claim 1, including an outer connection pad (2) intended to be electrically connected to an outer electronic system, extending throughout the readout structure (23) so as to come into contact with at least one conductive portion (22.1) of the upper metallization level.

8. A method for manufacturing a detection device (1) according to claim 1, including the following steps:
∘ making a first stack including a handle (31; 51) on which a sacrificial layer (32) made of a mineral material rests;
∘ transferring and molecular bonding, onto the first stack, of a SOI substrate (40) formed of a silicon substrate (41), an oxide layer (42) then a silicon thin layer (43), then removal of the silicon substrate (41);
∘ making the readout structure (23), the active electronic elements (23.1) being made starting from the silicon thin layer (43) over the SOI substrate (40),
∘ making the interconnection structure (22) over the readout structure (23), conductive portions of the upper metallization level being directly connected to the active electronic elements (23.1) through conductive vias (23.2);
∘ turning obtained stack over, then removing the handle (31; 51);
∘ making the absorbing membrane (11) over the sacrificial layer (32);
∘ eliminating the sacrificial layer (32) so as to suspend the absorbing membrane (11).

9. The manufacturing method according to claim 8, wherein making of the readout structure (23) includes the following steps:
∘ depositing a first insulating layer (23.3) covering the active electronic elements (23.1);
∘ making conductive vias (23.2), extending throughout the first insulating layer (23.3) so as to come into contact with the active electronic elements (23.1);
∘ making the anchor pillars (13), extending throughout the first insulating layer (23.3) and the sacrificial layer (32) so as to come into contact with the handle (31; 51).

10. The manufacturing method according to claim 8, including, before the transferring and molecular bonding step, a step of making an upper structure (24), resting on the sacrificial layer (32; 52), including a reflector (24.3) and a protective thin layer (24.2), which are covered with a third insulating layer (24.1).

11. The manufacturing method according to claim 10, wherein, the silicon thin layer (43) of the SOI substrate (40) is covered with a second insulating layer (23.4), so that, during transferring and molecular bonding, the second insulating layer (23.4) is brought into contact with the third insulating layer (24.1).

12. The manufacturing method according to claim 8, wherein, during the step of making the absorbing membrane (11), a thermometric transducer (11.1), for example a thermistor, is made.

13. The manufacturing method according to claim 8, wherein, during the step of making the first stack, a thermometric transducer (11.1), for example a junction diode or a transistor, is made over the handle (31; 51), then is covered with the sacrificial layer (32).
